# EUROPÄISCHE PATENTANMELDUNG

(11) **EP 1 217 708 A1**
(43) Veröffentlichungstag der Anmeldung: **26.06.2002**
(21) Anmeldenummer: 00811222.9
(22) Anmeldetag: 21.12.2000
(51) Int. Cl.: H02H 9/02, H01L 39/16, H01F 6/04, F17C 3/08

(54) **Vorrichtung der Supraleitungstechnik**

(71) Anmelder: ABB RESEARCH LTD., 8050 Zürich (CH)
(72) Erfinder: Paul, Willi, 5430 Wettingen (CH); Lakner, Martin, 5413 Birmenstorf (CH); Chen, Makan, 5405 Baden-Dättwil (CH); Donzel, Lise, 5430 Wettingen (CH)
(74) Vertreter: ABB Patent Attorneys

(57) **Zusammenfassung**

In einem supraleitenden Strombegrenzer 1 werden im Begrenzungsfall durch Verdampfen von Kühlflüssigkeit Druckwellen erzeugt, welche den Supraleiter schädigen können. Erfindungsgemäss wird der Strombegrenzer nicht in eine Kühlflüssigkeit eingetaucht, sondern mit einem Kühlfluid 22 in thermischen Kontakt gebracht, welches oberhalb der Betriebstemperatur keinen Phasenübergang aufweist, und somit im Begrenzungsfall nicht verdampft. Ein Kältereservoir 21, welches die kondensierte Phase eines gasförmigen Kühlfluids oder ein Kryokühler sein kann, bestimmt die Betriebstemperatur des Strombegrenzers. Ein Vorteil besteht darin, dass nun auch mehrere und unbeschränkt grosse plattenförmige Strombegrenzermodule 10,10' nebeneinander in dem Kühlfluid 22 angeordnet werden können.

## Beschreibung

### TECHNISCHES GEBIET

Die vorliegende Erfindung bezieht sich auf das Gebiet der Anwendung der Hochtemperatursupraleitung im Bereich der Stromversorgung. Sie betrifft eine Vorrichtung der Supraleitungstechnik gemäss dem Oberbegriff des Patentanspruchs 1.

### STAND DER TECHNIK

Hochtemperatursupraleiter finden beispielsweise Verwendung in supraleitenden Kurzschluss-Strombegrenzern für elektrische Verteil- oder Übertragungsnetze. Bei einem solchen Strombegrenzer wird ausgenutzt, dass ein Supraleiter bei einer entsprechend tiefen Betriebstemperatur seine Supraleitfähigkeit nur solange beibehält, als die Stromdichte eines ihn durchfliessenden Stromes unterhalb eines gewissen, als kritische Stromdichte bezeichneten Grenzwertes bleibt. Tritt im entsprechenden Stromversorgungsnetzwerk ein Kurzschluss auf, wächst der Strom im Strombegrenzer zu einem den kritischen Wert übertreffenden Fehlerstrom an.

Aber auch andere supraleitende Bauteile wie Übertragungskabel oder Transformatoren weisen inhärent eine kritische Stromstärke (I_{c}) auf. Im Nennbetrieb leiten diese Bauteile einen Nennstrom I_{N}, welcher kleiner ist als der kritische Strom I_{c}, verlustfrei. Auf Grund von Transienten, welche durch Schaltnetzkomponenten wie Filterkreise oder grosse Verbraucher im Versorgungsnetz erzeugt werden, kann dieser Nennstrom aber kurzzeitig zu einem Überstrom anwachsen.

Vorrichtungen auf Hochtemperatursupraleiterbasis werden normalerweise in ein flüssiges Kühlmedium, der Einfachheit halber vorzugsweise flüssigen Stickstoff (LN₂), welcher durch ein Kryostat genanntes Gefäss von der Umgebung thermisch isoliert ist, eingetaucht. Als Folge eines Fehler- oder Überstromes in einem supraleitenden Bauteil tritt der Supraleiter in den resistiven Zustand über, d.h. die am entsprechenden Abschnitt des Stromversorgungsnetzwerkes anliegende Spannung fällt zumindest kurzzeitig ganz (im Kurzschlussfall) oder teilweise am Supraleiter ab. Joulsche Wärme wird erzeugt, und der Supraleiter heizt sich unter Umständen bis weit über seine Betriebstemperatur hinaus auf und erwärmt auch das ihn umgebende Kühlmedium. Besteht dieses aus flüssigem Stickstoff, so wird eine grosse Menge davon in kurzer Zeit verdampft, so dass im Kryostaten ein Überdruck entsteht und Druck- oder Schockwellen sich fast explosionsartig ausbreiten. Dadurch beginnt die Supraleitervorrichtung zu vibrieren und erleidet einen irreparablen mechanischen Schaden, beispielsweise durch Rissbildung in der Hochtemperatursupraleiterkeramik oder durch Ablösung einer Leiter- oder Trägerschicht.

In der Deutschen Offenlegungsschrift DE-A 197 46 976 ist eine Hochtemperatursupraleiteranordnung zur Verwendung in einem Strombegrenzer dargestellt. Die Anordnung umfasst eine supraleitende Schicht und eine als elektrischer Bypass ausgebildete, gelochte Stahlplatte, welche mit der supraleitenden Schicht einen Leiterverbund bildet. Die Supraleiteranordnung kann zusätzlich mechanisch stabilisiert und elektrisch isoliert werden durch faserverstärkte Verbundwerkstoffe. In der Europäischen Patentschrift EP-B 789 368 ist eine vakuumisolierte supraleitende Einrichtung gut wärmeleitend mit einem Kryokühler verbunden und wird durch diesen indirekt gekühlt.

### DARSTELLUNG DER ERFINDUNG

Aufgabe der vorliegenden Erfindung ist es, bei Anwendungen der Hochtemperatursupraleitung im Bereich der Stromversorgung die mechanische Belastung der Supraleiter zu verringern und deren Verfügbarkeit zu erhöhen. Diese Aufgabe wird durch eine Vorrichtung der Supraleitungstechnik mit den Merkmalen des Patentanspruchs 1 und ein Verfahren zu deren Betrieb mit den Merkmalen des Patentanspruchs 10 gelöst.

Kern der Erfindung ist es, bei einer abrupten Erwärmung einer Supraleiteranordnung und eines ihn umgebenden Kühlmediums eine Verdampfung des Kühlmediums und das damit verbundene Auftreten von Schockwellen zu verhindern. Dies wird erreicht, indem als Kühlmedium für die Supraleiteranordnung ein Fluid gewählt wird, welches nicht bereits bei einer geringsten Erwärmung einen Phasenübergang untergeht. Dieses Kühlfluid steht in thermischem Kontakt mit einem weiteren Kühlmedium, welches ein Kältereservoir mit einer Nenntemperatur (T_{N}) bildet. Das genannte Kühlfluid ist somit entweder ein Gas oder eine Flüssigkeit mit einem Siedepunkt (T_{B}) oberhalb der Nenntemperatur T_{N}. Das Kältereservoir bestimmt im Normal- oder Nennbetriebsfall eine Betriebstemperatur der Supraleiteranordnung, diese liegt entsprechend nur wenig über der Nenntemperatur T_{N}. Das Kältereservoir selbst ist aber gleichzeitig nur schlecht thermisch an den Supraleiter gekoppelt und somit im Falle einer von diesem ausgehenden Erwärmung nicht oder nur verzögert betroffen.

Gemäss einer ersten Ausführungsform der erfindungsgemässen Vorrichtung ist das Kühlfluid die gasförmige Phase und das Kältereservoir die koexistierende flüssige Phase ein und desselben Kühlmediums. Die Nenntemperatur T_{N} entspricht der Siedetemperatur (T_{B}) des Kühlmediums, welche über den Druck ihrer Gasphase beeinflusst werden kann.

Gemäss einer zweiten Ausführungsform umfasst die Supraleiteranordnung einen Träger und einen Leiterverbund, welcher auf dem Träger aufgebracht ist und über diesen zusätzlich mit dem Kältereservoir thermisch verbunden ist. Die durch den Träger vermittelte zusätzliche Wärmeleitung beschleunigt insbesondere den Vorgang des erstmaligen Abkühlens von Raumtemperatur auf Betriebstemperatur anlässlich der Inbetriebnahme der Vorrichtung.

Das Problem der explosionsartigen Verdampfung von Kühlflüssigkeit ist insbesondere bei Strombegrenzern akut, da diese darauf ausgelegt sind, im Kurzschlussfall innert kürzester Zeit einen grossen Widerstand aufzubauen und viel Energie zu dissipieren. Resistive Strombegrenzer umfassend plattenförmige Module mit je einem elektrisch isolierenden Träger und beidseitig aufgebrachten Leiterbahnen sind umso stärker gefährdet, je grösser die Ausdehnung der Module ist. Dies deshalb, weil bei gleichbleibender Moduldicke die Schwingungsamplituden umso grösser sind, je grösser die Ausdehnung der Module, d.h. die Fläche der Platten, ist. Da erfindungsgemäss weniger mechanische Belastungen auftreten, ist es nun auch möglich, Module einzusetzen, welche eine Ausdehnung von mehr als 0.05 m² aufweisen.

Bei einer weiteren Ausführungsform für Strombegrenzer mit mehreren Modulen sind zwischen den Modulen thermische Ausgleichselemente zur Temperaturhomogenisierung vorgesehen, welche vorzugsweise in Kontakt mit dem Kältereservoir stehen und selber gut wärmeleitend sind oder porös. Die Module sind vorzugsweise so angeordnet, dass die von ihnen gebildeten Zwischenräume einen durchgehenden Kanal für das Kühlfluid bilden. Zur Unterstützung der Zirkulation des Kühlfluids kann eine Pumpe eingesetzt werden.

Das erfindungsgemässe Verfahren ist dadurch charakterisiert, dass in dem Fall, wo Kühlfluid und Kältereservoir zwei Phasen ein und desselben Kühlmediums sind, während des Betriebs die Supraleiteranordnung laufend mit der flüssigen Phase, d.h. einem flüssigen Kühlmedium benetzt oder beregnet wird. Das gasförmige Kühlfluid entsteht also fortwährend durch Verdampfen von auf den Supraleiter auftreffenden Tropfen.

Weitere vorteilhafte Ausführungsformen gehen aus den abhängigen Patentansprüchen hervor.

### KURZE BESCHREIBUNG DER FIGUREN

Nachfolgend wird die Erfindung anhand von Ausführungsbeispielen im Zusammenhang mit den Zeichnungen näher erläutert. Diese zeigen je einen Querschnitt durch einen resistiven supraleitenden Strombegrenzer, und zwar in
Fig.1 mit einem die Module des Strombegrenzers umgebenden Kühlfluid, welches die gasförmige Phase eines auf dem Boden des Kryostaten angesammelten flüssigen Kühlmediums ist;
Fig.2 mit einem Kryostaten, welcher für das Kühlfluid und ein flüssiges Kühlmedium getrennte Behälter aufweist;
Fig.3 mit einem durch die Module gebildeten Kanal, in welchem das Kühlfluid zirkuliert; und
Fig.4 mit einem Beregnungsmittel zur Benetzung der Module mit einem flüssigen Kühlmedium.

Die in den Zeichnungen verwendeten Bezugszeichen sind in der Bezugszeichenliste zusammengefasst. Grundsätzlich sind gleiche Teile mit denselben Bezugszeichen versehen.

### WEGE ZUR AUSFÜHRUNG DER ERFINDUNG

In den Figuren ist jeweils ein resistiver Strombegrenzer 1 dargestellt, wobei die Erfindung selbstverständlich auch bei anderen Hochtemperatursupraleiteranordnungen eingesetzt werden kann. Der Strombegrenzer 1 umfasst 4 plattenförmige Module 10,10', welche elektrisch in Serie geschaltet sind und von einem Strom I durchflossen werden. Jedes Modul 10 umfasst einen zweidimensionalen Träger 11, auf dessen zumindest einer Trägerhauptfläche 110 eine Leiterbahn beispielsweise in Form eines Mäanders oder einer Spirale aufgebracht ist. Die Leiterbahn besteht aus einem Leiterverbund 12 aus einem Supraleiter und einem Normalleiter, welcher mit dem Supraleiter flächenhaft verbunden ist und einen elektrischen Bypass für diesen darstellt. Weiter sind nicht dargestellte elektrisch isolierende und/oder mechanisch stützende Schichten, beispielsweise aus Faserverbundwerkstoff, als Abdeckung der Leiterbahnen denkbar. Die Module 10,10' sind nebeneinander angeordnet und bilden Zwischenräume 13. Die Module 10,10' beziehungsweise deren Träger 11 sind auf dem Boden oder den Wänden eines den Strombegrenzer 1 umgebenden Kryostaten 20 abgestützt. Damit keine Luftfeuchtigkeit einfriert ist der Kryostat 20 geschlossen und mit einem nicht dargestellten Überdruckventil versehen.

Ein erstes Kühlmedium dient als Kältereservoir 21, welches sich auf einer Nenntemperatur T_{N} (T_{N} = 77 K für flüsssigen Stickstoff LN₂ bei Atmosphärendruck) befindet. Die der Trägerhauptfläche 110 abgewandte Seite eines Leiterverbundes 12 steht mit einem Kühlfluid 22 in thermischem Kontakt, d.h. der Leiterverbund 12 ist, unmittelbar oder eventuell über die genannte Faserverbundschicht, an dieses Kühlfluid 22 thermisch angekoppelt. Über das Kühlfluid 22 steht der Leiterverbund 12 auch mit dem Kältereservoir 21 in thermischem Kontakt und weist somit im Normalfall eine Betriebstemperatur auf, welche gleich der Nenntemperatur T_{N} ist oder leicht darüber liegt. Der genannte thermische Kontakt des Leiterverbundes 12 mit dem Kältereservoir 21 erfolgt aber nie direkt, sondern über das Kühlfluid 22 oder den Träger 11, welche Wärmezwischenspeicher oder -puffer bilden und eine vom Leiterverbund 12 ausgehende kurzzeitige Erwärmung nur langsam weiterleiten.

Im Fehler- oder Kurzschlussfall erzeugt nach Überschreiten eines kritischen Wertes der Fehlerstrom im Leiterverbund 12 Joul'sche Wärme. Je nach Auslegung des Strombegrenzers 1 erwärmt sich dabei der Supraleiter um zumindest einige 10 K. Erfindungsgemäss weist nun das unmittelbar mit dem Leiterverbund 12 in thermischem Kontakt stehende Kühlfluid 22 keinen Phasenübergang auf, falls es in den genannten Fällen ebenfalls erwärmt wird. Handelt es sich bei dem Kühlfluid 22 um eine Flüssigkeit und nicht um ein Gas, ist es ausreichend, wenn der Siedepunkt T_{B} der Flüssigkeit höher liegt als die Nenntemperatur T_{N}. Kraft ihrer spezifischen Wärme fungiert die Kühlflüssigkeit in diesem Falle selber als Wärmespeicher, und die bei der Siedetemperatur T_{B} einsetzende Blasenbildung erfolgt, falls überhaupt, erst verzögert.

Sind das Kältereservoir 21 und das Kühlfluid 22 verschiedene Phasen eines Kühlmediums, ist dafür infolge seiner Verfügbarkeit Stickstoff N₂ prädestiniert. Flüssiger und gasförmiger Stickstoff koexistieren bei einer Siedetemperatur T_{B}, welche bei Atmosphärendruck 77 K beträgt und durch Absenken des Druckes auf 0.3 bar auf 68 K gesenkt werden kann. In den Figuren zeigt eine Wellenlinie jeweils eine Phasengrenzfläche zwischen einer flüssigen und einer gasförmigen Phase eines Kühlmediums an. Allgemein darf das gasförmige Kühlfluid 22 nicht unter einen Druck von 0.1 bar verdünnt werden, da ansonsten seine Kühlleistung beziehungsweise Wärmeleitfähigkeit zu stark beeinträchtigt wird.

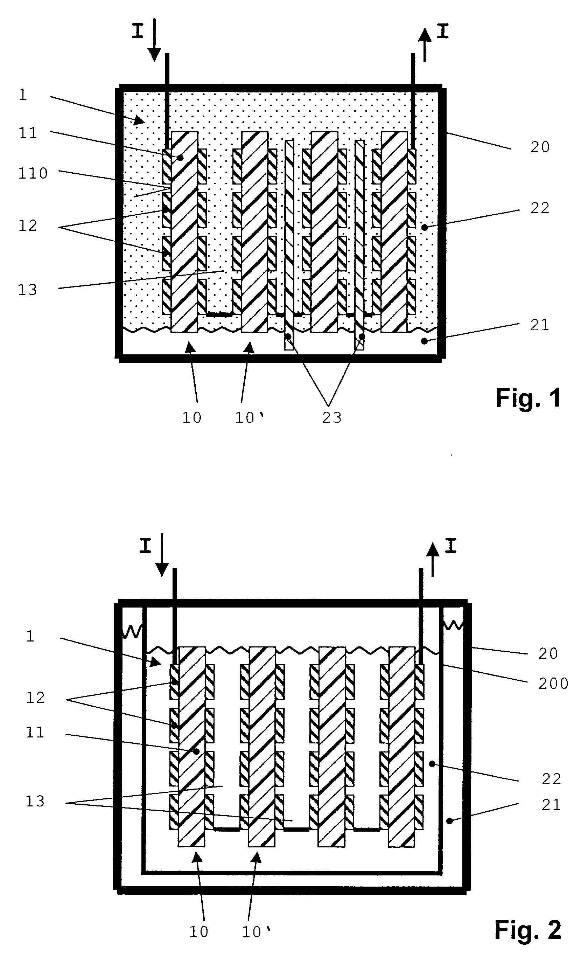

In Fig.1 ist der untere Teil der Module 10,10' des Strombegrenzers 1 in das Kältereservoir 21 der Temperatur T_{N} eingetaucht, welches als flüssiges Kühlmedium den Boden des Kryostaten 20 bedeckt. Um die Ausbildung von Temperaturgradienten zwischen dem Boden des Kryostaten 20 und dem oberen Teil der Module zu verhindern, sind thermische Ausgleichselemente 23 eingebaut. Der Übersicht halber sind in Fig.1 nur zwei solcher Ausgleichselemente 23 gezeichnet. Sie bestehen aus einem gut wärmeleitenden Material, wobei unter Umständen auch Metalle wie Kupfer oder Aluminium denkbar sind, oder aus einem porösen, saugfähigen Material, so dass durch Kapillarkräfte das flüssige Kühlmedium in einen Bereich des Zwischenraumes 13 aufsteigt.

In Fig.2 teilt eine thermisch gut leitende Trennwand 200 das Volumen des Kryostaten 20 in ein inneres und ein äusseres Teilvolumen, welches das innere Teilvolumen umgibt. In Letzterem befindet sich die Supraleiteranordnung 1 und das Kühlfluid 22, das äussere Teilvolumen enthält ein flüssiges Kühlmedium als Kältereservoir 21. Das flüssige Kühlmedium und das Kühlfluid 22 sind also in getrennten Teilen des Kryostaten 20 untergebracht und können in diesem Fall auch unterschiedliche Drücke aufweisen. Das äussere Teilvolumen enthält beispielsweise durch Unterdruck auf eine Nenntemperatur T_{N} von 65 K gekühlten flüssigen Stickstoff LN₂. Das den Supraleiter umgebende Kühlfluid 22 ist ebenfalls flüssiger Stickstoff LN₂, aber unter mindestens Atmosphärendruck stehend. Dessen Siedepunkt T_{B} beträgt also weiterhin 77 K oder mehr, nur wird er durch das umgebende Kältereservoir 21 auf Nenntemperatur T_{N} unterkühlt. Somit besteht bei Erwärmung der Anordnung eine Temperaturreserve von über 12 K, erst nachher wird auch das Kühlfluid 22 verdampft. Als Kühlfluid 22 anstelle von flüssigem Stickstoff LN₂ kommen aber auch von Stickstoff verschiedene, gasförmige oder flüssige Kühlmedien in Frage. Als Letztere seien beispielsweise Trichlorpropan C₃H₅Cl₃ mit einer Siedetemperatur T_{B} von 429 K oder Stickstofftrifluorid NF₃ (T_{B} = 144 K) oder Sauerstoffdifluorid FO₂ (TB = 128 K), deren Schmelzpunkte alle deutlich unterhalb 77 K liegen, genannt. Ist die Trennwand 200 aus einem Isolator gefertigt, dient sie gleichzeitig der dielektrischen Isolation des Strombegrenzers 1 gegenüber einer möglicherweise metallischen, äusseren Wand des Kryostaten 20.

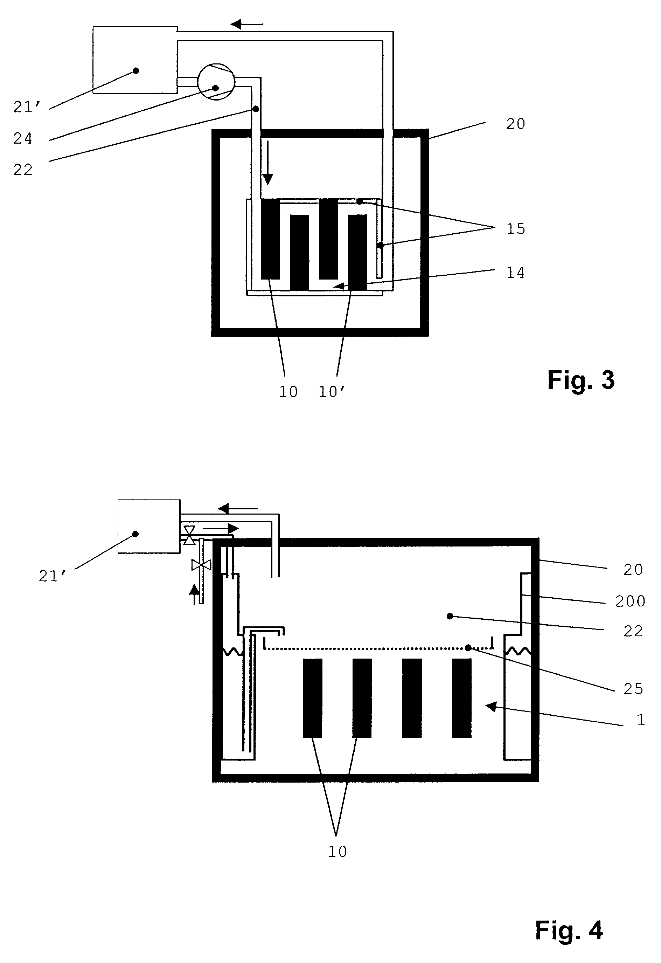

In Fig.3 ist der Strombegrenzer nur noch durch vier Module 10,10' angedeutet. Diese sind so angeordnet, dass die Zwischenräume 13 hintereinandergeschaltet sind und ein Kanal 14 für das Kühlfluid 22 entsteht. Zusätzliche Stützelemente 15 bilden weitere Wände des Kanals 14. Mittels einer Pumpe 24 wird das Kühlfluid 22 durch den Kanal 14 gepresst und der erforderliche Massentransport gewährleistet. Damit wird verhindert, dass das letzte Modul 10' viel wärmer ist als das erste Modul 10. Das Kühlfluid 22 wird nach Durchlaufen des Kanals 14 in einem als Kältereservoir 21' fungierenden Kryokühler wieder auf T_{N} gekühlt. Anstelle der dargestellten Anordnung, welche einer fluidmässigen Serieschaltung der Zwischenräume gleichkommt, kann das Kühlfluid 22 auch aufgeteilt werden und mehrere Zwischenräume parallel durchströmen.

In Fig.4 ist entlang der Aussenwand des Kryostaten 20 ebenfalls ein äusseres Teilvolumen als Behälter für ein flüssiges Kühlmedium vorgesehen. Von diesem gehen Beregnungsmittel aus, welche es erlauben, die Supraleiteranordnung 1 zu benetzen oder zu beregnen. Dabei handelt es sich erfindungsgemäss um eine Dusche und nicht etwa um ein Vollbad. Die Benetzung erfolgt über eine Anordnung mit Düsen oder indem von einem Lochblech 25 mit kleinen Öffnungen Tropfen flüssigen Kühlmediums auf die Supraleiteranordnung 1 fallen. Die auf den Leiterverbund auftreffenden Tropfen verdampfen auch im Nennbetrieb wegen der unvermeidbaren Restverluste im Supraleiter sehr rasch, so dass sich kein kontinuierlicher Flüssigkeitsfilm auf seiner Oberfläche bildet. Am Boden des Kryostaten 20 sammelt sich wenig bis gar keine Flüssigkeit an. Das gasförmige Kühlfluid 22 wird in einem Kryokühler als Kältereservoir 21' wieder kondensiert. Die Kühlleistung wird über den hydrostatischen Druck im äusseren Teilvolumen des Kryostaten 20 geregelt. Mittels Zufuhr von unter Druck stehendem Gas kann die Kühlleistung schnell erhöht werden, was zur Abkühlung der Supraleiteranordnung 1 nach einem Kurzschluss geeignet ist.

Es versteht sich, dass das genannte Kältereservoir 21, welches in Fig.1 und Fig.2 durch ein flüssiges Kühlmedium gebildet wird, auch eine auf der Nenntemperatur T_{N} operierende Kältemaschine (Kryokühler) sein kann. Andererseits kann der ebenfalls die Funktion eines Kältereservoirs 21' übernehmende Kryokühler gemäss Fig.3 und Fig.4 auch durch ein Kühlmedium substituiert werden, ohne dass am Prinzip der gezeigten Ausführungsform etwas ändert. Kryokühler wie Sterling- oder Austauschkühler basieren auf bekannten physikalischen Prinzipien und stellen bei einer bestimmten Temperatur T_{N} eine gewisse Kühlleistung zur Verfügung.

Das Problem der durch mechanische Belastung hervorgerufenen Rissbildung in Hochtemperatursupraleiterkeramiken ist nicht auf einen bestimmten Hochtemperatursupraleiter-Typ und/oder ein bestimmtes Verfahren zu seiner Herstellung beschränkt. In Strombegrenzeranwendungen eingesetzt wird beispielsweise schmelzprozessiertes Bi₂Sr₂CaCu₂O₈ als polykristallines Bulkmaterial mit Schichtdicken vorzugsweise zwischen 50 und 1000 µm. Damit lassen sich Module präparieren mir einer Ausdehnung in der Ebene senkrecht zur Schnittebene der Figuren von bis zu einigen 0.1 m². Module dieser Grösse sind allerdings wie gesagt bei Vibrationen mehr gefährdet, und dies trotz des Einsatzes von Faserverbundwerkstoffen oder von elektrisch isolierten metallischen Substraten als Träger oder als zusätzliche Verstärkungsschichten. Aus diesem Grund ist die Verwendung grosser Module erst dank der erfindungsgemässen Vibrationsvermeidung möglich. Die Module weisen im Übrigen untereinander einen seitlichen Abstand von 2 - 20 mm auf.

Die vorgängig am Beispiel eines resistiven supraleitenden Strombegrenzers erläuterte Erfindung ist keineswegs auf planare Modul- oder Trägergeometrien gebunden. Der erfindungsgemässe Verzicht auf ein Eintauchen der Supraleiteranordnung in eine Kühlflüssigkeit ist auch bei anderen Bauteilen der Supraleitungstechnik sinnvoll. Beispielsweise kann der Träger ein Spulenkörper eines Transformators sein, auf welchen die Leiterbahnen als Wicklungen aufgebracht sind. Auch hier resultieren weniger mechanische Beschädigungen, und dementsprechend ein verringerter Austauschbedarf und eine höhere Verfügbarkeit der Vorrichtung.

### BEZUGSZEICHENLISTE

- 1: Strombegrenzer
- 10,10': Modul
- 11: Träger
- 110: Trägerhauptfläche
- 12: Leiterverbund
- 13: Zwischenraum
- 14: Kanal
- 15: Stützelement
- 2: Kühlanordnung
- 20: Kryostat
- 200: Trennwand
- 21,21': Kältereservoir
- 22: Kühlfluid
- 23: thermisches Ausgleichselement
- 24: Pumpe
- 25: Lochblech

## Patentansprüche

1. Vorrichtung der Supraleitungstechnik, umfassend
a) eine Hochtemperatursupraleiteranordnung mit einem Träger (11), welcher eine Trägerhauptfläche (110) aufweist, und einem Leiterverbund (12), welcher auf der Trägerhauptfläche (110) angeordnet ist und Hochtemperatursupraleitermaterial aufweist, und
b) eine Kühlanordnung mit einem Kältereservoir (21), welches eine Nenntemperatur (T_{N}) aufweist, und einem Kühlfluid (22), welches mit dem Kältereservoir (21) in thermischem Kontakt steht, wobei
c) der Leiterverbund (12) über eine der Trägerhauptfläche (110) abgewandte Seite vorwiegend mit dem Kühlfluid (22) in thermischem Kontakt steht
**dadurch gekennzeichnet, dass**
d) das Kühlfluid (22) ein Gas ist oder eine Flüssigkeit, deren Siedetemperatur (T_{B}) über der Nenntemperatur (T_{N}) liegt.

2. Vorrichtung nach Anspruch 1, **dadurch gekennzeichnet, dass** das Kühlfluid (22) eine gasförmige Phase eines Kühlmediums ist und das Kältereservoir (21) eine flüssige Phase desselben Kühlmediums umfasst.

3. Vorrichtung nach Anspruch 1, **dadurch gekennzeichnet, dass** der Träger (11) mit dem Kältereservoir (21) in thermischem Kontakt steht.

4. Vorrichtung nach Anspruch 1, **dadurch gekennzeichnet, dass** das Kältereservoir (21) ein Kühlmedium umfasst, welches durch eine Trennwand (200) vom Kühlfluid (22) getrennt ist und sich von Letzterem hinsichtlich stofflicher Zusammensetzung oder Druck unterscheidet.

5. Vorrichtung nach einem der Ansprüche 1 bis 4, **dadurch gekennzeichnet, dass** die Hochtemperatursupraleiteranordnung ein resistiver Strombegrenzer (1) mit plattenförmigen Modulen (10,10') ist.

6. Vorrichtung nach Anspruch 5, **dadurch gekennzeichnet, dass** die Module (10,10') eine Ausdehnung von mindestens 0.05 m² aufweisen.

7. Vorrichtung nach Anspruch 5, **dadurch gekennzeichnet, dass** mindestens zwei Module (10,10') nebeneinander angeordnet sind und einen Zwischenraum (13) bilden, in welchem ein thermisches Ausgleichselement (23) zur Temperaturhomogenisierung vorgesehen ist.

8. Vorrichtung nach Anspruch 5, **dadurch gekennzeichnet, dass** die Module (10,10') einen Kanal (14) für das Kühlfluid (22) bilden.

9. Vorrichtung nach Anspruch 8, **dadurch gekennzeichnet, dass** eine Pumpe (24) zur Zirkulation des Kühlfluids (22) durch den Kanal (14) vorgesehen ist.

10. Verfahren zum Betrieb einer Vorrichtung umfassend eine Hochtemperatursupraleiteranordnung und eine Kühlanordnung, wobei
a) ein Supraleitermaterial umfassender Leiterverbund (12) auf einer Trägerhauptfläche (110) eines Trägers (11) angeordnet ist und
b) über eine dem Träger (11) abgewandte Seite mit einem Kühlfluid (22) aus einer gasförmigen Phase eines Kühlmediums in thermischem Kontakt steht,
c) welches Kühlfluid (22) mit einem Kältereservoir (21) umfassend eine flüssige Phase des Kühlmediums in thermischem Kontakt steht,
**dadurch gekennzeichnet, dass**
d) die Hochtemperatursupraleiteranordnung (1) mit der flüssigen Phase des Kühlmediums benetzt wird.
